# EUROPEAN PATENT APPLICATION

(11) **EP 0 773 582 A2**
(43) Date of publication of application: **14.05.1997**
(21) Application number: 96118203.7
(22) Date of filing: 13.11.1996
(51) Int. Cl.: H01L 21/762, H01L 21/308

(54) **Method of forming a trench isolation structure in an integrated circuit**

(30) Priority: 13.11.1995 US 6616
(71) Applicant: TEXAS INSTRUMENTS INCORPORATED, Dallas Texas 75265 (US)
(72) Inventor: Chen, Ih-Chin, Richardson, TX 75082 (US)
(74) Representative: Schwepfinger, Karl-Heinz, Dipl.-Ing.

(57) **Abstract**

A method of making a semiconductor device or integrated circuit produces trench isolation structures having rounded corners in order to reduce gate oxide weakness and to avoid the so-called "double hump" curve produced by the corner effect. A LOCOS oxide is removed from the surface of a silicon substrate to produce a depression in the surface. A silicon dioxide or silicon nitride layer is deposited over the surface including the silicon nitride used in the LOCOS process. The surface in anisotropically etched to form sidewall spacers either side of the area where the trench is to be formed. The substrate is then etched to form a trench. In an alternative method, nitride sidewalls are formed prior to removing the LOCOS oxide. The resulting structure is anisotropically etched to leave sidewalls on either side of the trench location, the sidewalls being made of the silicon nitride sidewall and the remainder of the LOCOS oxide. The substrate would then be etched to form the trench.

## Description

The present invention relates to semiconductor devices, and more particularly to methods of forming a trench isolation structure.

### BACKGROUND OF THE INVENTION

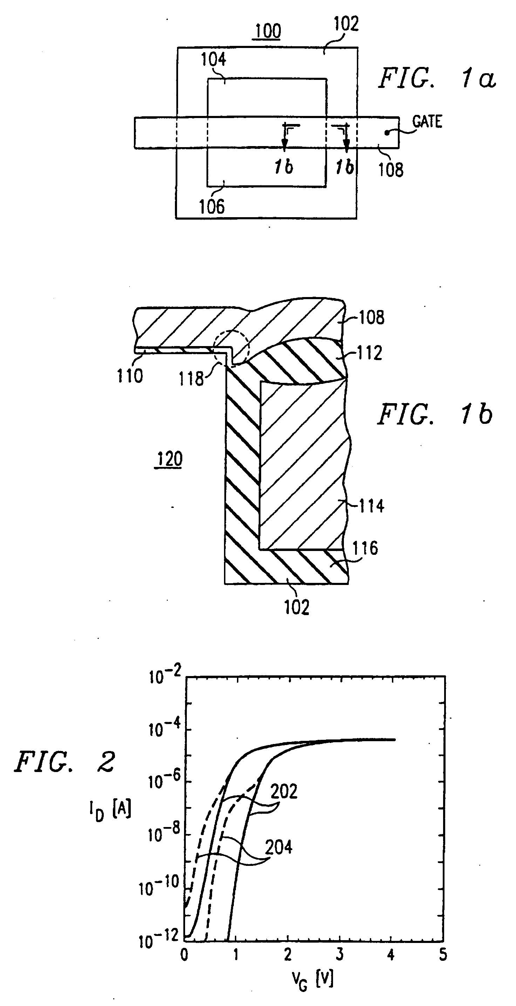

Trench isolation techniques commonly use either deposited or thermally grown silicon dioxide as a trench lining material. Most of the trench process steps are typically done before the gate oxide is grown and the polysilicon gate is deposited. As a result of this process, most trench isolation structures suffer a common edge leakage problem for the active transistors. Figure 1a shows a top view of a trench isolated transistor 100 having isolation trench 102, a source 104, a drain 106, and a gate 108. Figure 1b shows a partial cross section of this transistor in the gate-to-trench overlap area along section line 1b-1b. The trench 102 is lined with thermally grown silicon dioxide 116. The trench may be partially filled with polycrystalline silicon 114 covered by CVD deposited silicon dioxide 112 or may be entirely filled with silicon dioxide 112.

Before the gate oxide 110 is grown, a planarization step, such as chemical-mechanical polishing (CMP) is performed to planarize the surface and the thermal oxide is removed in a deglaze step using a wet HF etch. The HF etch is an isotropic process which will attack the corners shown at 118 from both the top and side causing that area to be more deeply etched. This problem is exacerbated by the fact that the deposited oxide is etched more slowly than the thermal oxide.

This sharp corner creates two known problems in completing the active device. Firstly, when the gate oxide is formed, it will not form well over the sharp corner resulting in a weak oxide which may produce excessive leakage or cause a short in the transistor. Secondly, when the polycrystalline silicon gate is deposited over the gate oxide, it will be deposited both to the side of and the top of the channel. The two dimensional effect at the corner area causes the corner area of the channel to be more influenced by the gate bias than the rest of the channel. Therefore, the threshold voltage at that local area is lower and the leakage is higher. Figure 2 shows the I_{d}-Vₛ curve of a transistor having this edge leakage problem as compared with the same characteristic of a normal device. As compared with the normal device curve 202, the curve of the transistor with the sharp corner exhibits the so-called "double hump" characteristic. This problem may increase as the channel width is narrowed because the effects of the trench which exists around the periphery of the device (see Figure 1a) will become more prominent as the channel width is decreased.

### SUMMARY OF THE INVENTION

It is a general object of the present invention to provide a method for producing a rounded-corner trench isolation structure for a semiconductor device.

Another object of the present invention is making a semiconductor integrated circuit having a rounded-corner trench isolation structure for isolating a pair of semiconductor devices from each other and at least one of the devices from a periphery of the integrated circuit.

Yet another object of the invention is to make a semiconductor device having a rounded-corner trench isolation structure which is simple, reliable and reproducible.

A further object of the invention is to produce an integrated circuit having semiconductor devices utilizing trench isolation structures in which the devices do not have the subthreshold hump effect which is associated with a sharp trench corners.

These and other objects and advantages of the present invention are provided in accordance with one aspect of the invention by a method of making a semiconductor device having a rounded-corner trench isolation structure in which a LOCOS oxide is formed on a surface of a silicon substrate at a location where a trench is to be formed. The LOCOS oxide is removed to leave a depression in the surface at the trench location. A first dielectric layer is formed on the surface and anisotropically etched to form dielectric spacers on sides of the trench location. A trench is then etched at the trench location.

A further aspect of the invention comprises a method of making a semiconductor device having a rounded-corner trench isolation structure in which a silicon nitride layer is formed on a surface of a silicon substrate and patterned to expose the surface at a location where a trench is to be formed. A LOCOS oxide is formed on the surface at the trench location. The LOCOS oxide is removed to leave a depression in the surface at the trench location. A silicon dioxide layer is formed on the surface and anisotropically etched to form spacers on sides of the silicon nitride layer adjacent to the trench location. A trench is etched at the trench location. The spacers are removed and the trenches filled with a second silicon dioxide layer. The second silicon dioxide layer is planarized and the silicon nitride layer is removed. Gate oxide is formed over the second dielectric layer and gate polycrystalline silicon is formed over the gate oxide.

Yet another aspect of the invention includes a method of making a semiconductor device having a rounded-corner trench isolation structure in which a first silicon nitride layer is formed on a surface of a silicon substrate and patterned to expose said surface at a location where a trench is to be formed. A LOCOS oxide is formed on the surface at the trench location. The LOCOS oxide is removed to leave a depression in the surface at the trench location. A second silicon nitride layer is formed on the surface and anisotropically etched to form spacers on sides of the second silicon nitride layer adjacent to the trench location. A trench is etched at the trench location. The spacers are removed and the trenches filled with a silicon dioxide layer. The second silicon nitride layer is planarized and the first silicon nitride layer removed. A gate oxide is formed over the second silicon nitride layer and gate polycrystalline silicon is formed over the gate oxide.

A still further object of the invention includes a method of making a semiconductor device having a rounded-corner trench isolation structure in which a LOCOS oxide is formed on a surface of a silicon substrate where a trench is to be formed, the LOCOS oxide having a thickness of not more than substantially 1500 angstroms. Silicon nitride sidewall spacers are formed on either side of the trench location. The LOCOS oxide is removed except where it is protected by the sidewall spacers and a trench is etched at the trench location.

Yet another aspect of the invention includes a method of making a semiconductor device having a rounded-corner trench isolation structure in which a silicon nitride layer is formed on a surface of a silicon substrate said silicon nitride layer being patterned to expose the surface at a location where a trench is to be formed. A LOCOS oxide is formed on the surface at the trench location, the LOCOS oxide having a thickness of not more than substantially 1500 angstroms. Silicon nitride sidewall spacers are formed on sides of the silicon nitride layer adjacent the trench location. The LOCOS oxide is removed except where it is protected by the sidewall spacers. A trench is etched at the trench location and the trench is filled with a silicon dioxide layer. A surface of the silicon dioxide trench-filling layer is planarized. The patterned silicon nitride layer is removed. A gate oxide is formed over an active area of the device and gate polycrystalline silicon is formed over the gate oxide.

Another aspect of the invention comprises a method of making a semiconductor integrated circuit having a rounded-corner trench isolation structure in which a LOCOS oxide is formed on a surface of a silicon substrate at a first trench location to isolate a pair of semiconductor devices from each other and at a second location to isolate at least one of the devices from a periphery of the integrated circuit. Silicon nitride sidewall spacers are formed on either side of each of the trench locations. The LOCOS oxide is removed except where it is protected by the sidewall spacers and a trench is etched at each of the trench locations.

A further aspect of the invention includes a method of making a semiconductor integrated circuit having a rounded-corner trench isolation structure in which a silicon nitride layer is formed on a surface of a silicon substrate, the silicon nitride layer being patterned to expose the surface at a first location where a first trench to isolate a pair of semiconductor devices from each other is to be formed and at a second location where a second trench to isolate at least one of the devices from a periphery of said integrated circuit is to be formed. A LOCOS oxide is formed on the surface at the trench locations. Silicon nitride sidewall spacers are formed on sides of the silicon nitride layer adjacent the trench locations. The LOCOS oxide is removed except where it is protected by the sidewall spacers. A trench is etched at each of the trench locations and each of said trenches is filled with a silicon dioxide layer. A surface of each of the silicon dioxide trench-filling layers is planarized. The patterned silicon nitride layer is removed. A gate oxide is formed over an active area of the device and gate polycrystalline silicon is formed over the gate oxide.

### BRIEF DESCRIPTION OF THE DRAWINGS

The present invention will now be further described, by way of example with reference to embodiments illustrated in the accompanying drawings in which:
Figure 1a is a top view of a semiconductor device employing trench isolation;
Figure 1b is a partial cross-section of Figure 1a along section line 1b-1b showing the gate-to-trench overlap area;
Figure 2 illustrates the I_{d} -Vₛ curve of a normal semiconductor device and one showing the double hump curve caused by the corner effect;
Figure 3a shows the top view of a pair of semiconductor devices on a silicon substrate;
Figures 3b-3h show a cross-section of Figure 3a along section line 3b-3b showing the stages of processing of one embodiment of the present invention;
Figures 3i-3o show the same cross-section of Figure 3a showing the additional process steps needed to produce a transistor;
Figures 4a-4e show a cross-section of Figure 3a along section line 3b-3b showing the process steps for producing the trench isolation structure in accordance with a second embodiment of the invention which starts with the process shown in Figure 3d, and;
Figures 4f - 4h show the same cross-section of Figure 3a showing the steps needed to complete the trench isolation prior to forming the transistor.

### DETAILED DESCRIPTION

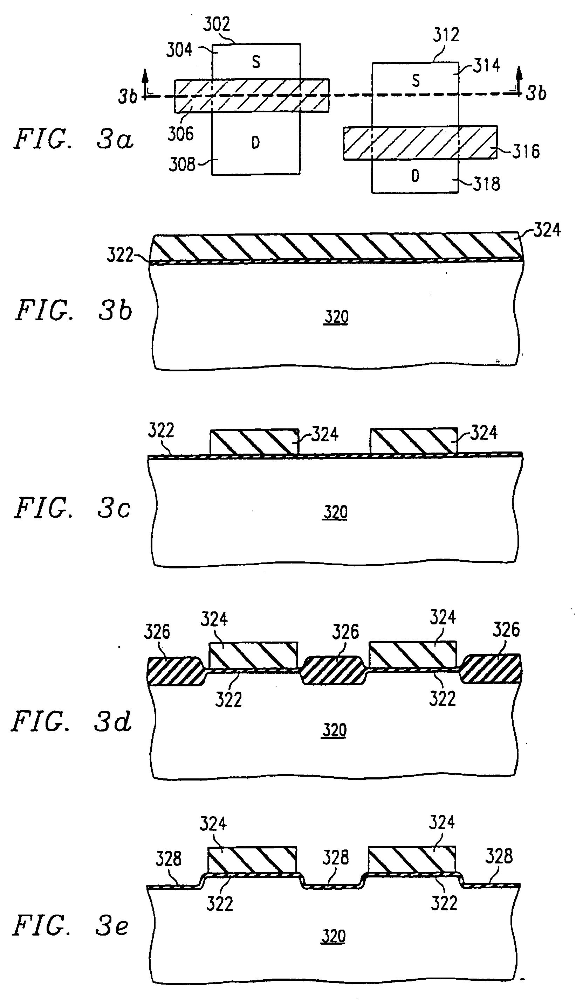

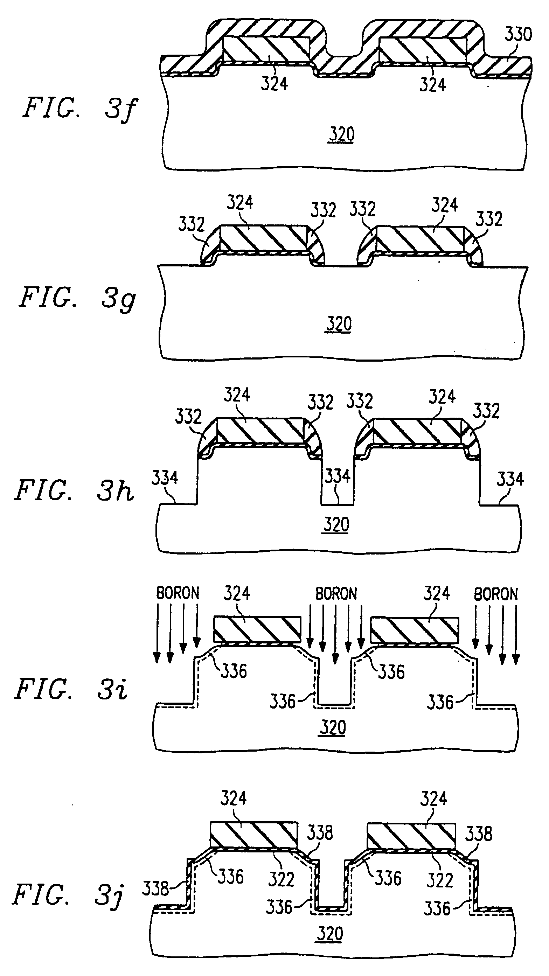

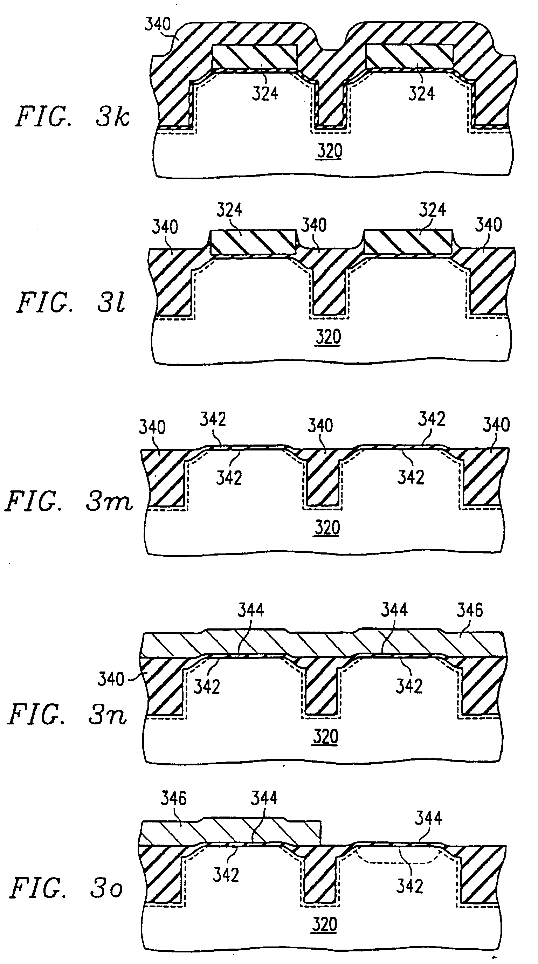

Figure 3a shows a top view of two semiconductor devices 302 and 312 which are to be isolated from each other. The technique of the present invention is equally applicable to P-type or N-type devices. Transistor 302 has a source 304, a gate 306 and a drain 308. Transistor 312 has a source 314, a gate 316 and a drain 318. Figures 3b-3h are a cross-section of Figure 3a along section line 3b-3b which show the process steps necessary to make the trench isolation structure. Figures 3i-3o show the completion of the structure to forming the gate polysilicon layer.

The first step in forming the trench isolation structure is to form a LOCOS oxide layer. As is well known to those skilled in the art, the process of forming a LOCOS oxide begins with the formation of a thermal pad or a buffer oxide 322, of 100 to 300 angstroms thickness on silicon substrate 320. A silicon nitride layer 324, of 1000 to 2000 angstroms thickness is formed by chemical vapor deposition (CVD) or other suitable process. The pad oxide serves as a buffer between the silicon substrate and the silicon nitride because of the high stress at a silicon nitride - silicon interface which will cause dislocations in the silicon, as is well known to those skilled in the art.

In Figure 3c, the silicon nitride 324 has been patterned by microlithographic techniques so that the silicon nitride is removed in those areas in which the LOCOS oxidation is to be formed. LOCOS oxidation regions 326 of 300 to 4000 angstroms in thickness are formed in the areas not protected by the silicon nitride as shown in Figure 3d. The LOCOS oxidation is typically formed by exposing the substrate to high temperature steam at temperatures between 900 and 1100 degrees centigrade. The LOCOS process described above is well known in the art.

The next step in the process is to deglaze the LOCOS oxide utilizing a wet etch process. When silicon dioxide is formed by oxidizing the surface of the silicon substrate, approximately 45% of the resulting silicon dioxide is silicon taken from the surface of the substrate. Thus, when the LOCOS oxide is deglazed, it leaves a depression 328 in the surface of the substrate. The pad oxide 322 which was used in the deglazing process, is then regrown, as shown in Figure 3e. The silicon dioxide or silicon nitride layer 330 is then deposited over the resulting structure, as shown in Figure 3f.

The silicon dioxide or silicon nitride layer 330 is then patterned by microlithographic techniques and etched utilizing an anisotropic etch to form sidewall spacers 332, as shown in Figure 3g. The structure is then subjected to a silicon etch which etches the silicon substrate 320 to form trenches 334. The trenches thus formed have sloped and rounded corners as can be seen from Figure 3h.

The process for forming the sloped and rounded corners is complete at this point. The trench isolation process will proceed from here. For completeness of disclosure, the following discussion and Figure 3i-3o show one example of completing a trench isolation process. Other processes can be used without departing from the present invention.

In Figure 3i the silicon dioxide or silicon nitride spacers have been removed by a wet etch, for example, and an optional rotational or vertical channel stop implant is performed. As shown, the implant is boron for NMOS devices; phosphorous would be utilized for PMOS devices as is well known in the art.

Pad oxide 338 is grown by thermal oxidation over the surfaces of the trench and over the implanted channel stop, if used, as shown in Figure 3j. A silicon dioxide or silicon nitride layer 340 is deposited over the resulting structure in order to fill in the trenches as shown in Figure 3k. The surface of the silicon dioxide or silicon nitride deposition is planarized by, for example, chemical mechanical polishing (CMP) to expose the surface of the silicon nitride layer 324 and to produce a flat surface for forming the gate, as shown in Figure 3l. The nitride layer 324 is removed by a wet etch, for example, and a dummy gate oxide 342 is grown by thermal oxidation as shown in Figure 3m. The dummy oxide is then deglazed to expose the active area of the silicon. The dummy oxide serves as a sacrificial oxide which is used to clean the surface of the silicon before further processing. In Figure 3n, a thermal gate oxide 344 is grown and a polycrystalline silicon gate 346 is deposited. The process is completed in Figure 3o by etching the gate polycrystalline silicon and implanting the source and drain regions. The CMOS integrated circuit can then be processed in a conventional manner.

As can be seen in Figures 3n and 3o, the polycrystalline silicon gate does not wrap around the corner of the trench to produce the corner effect described above.

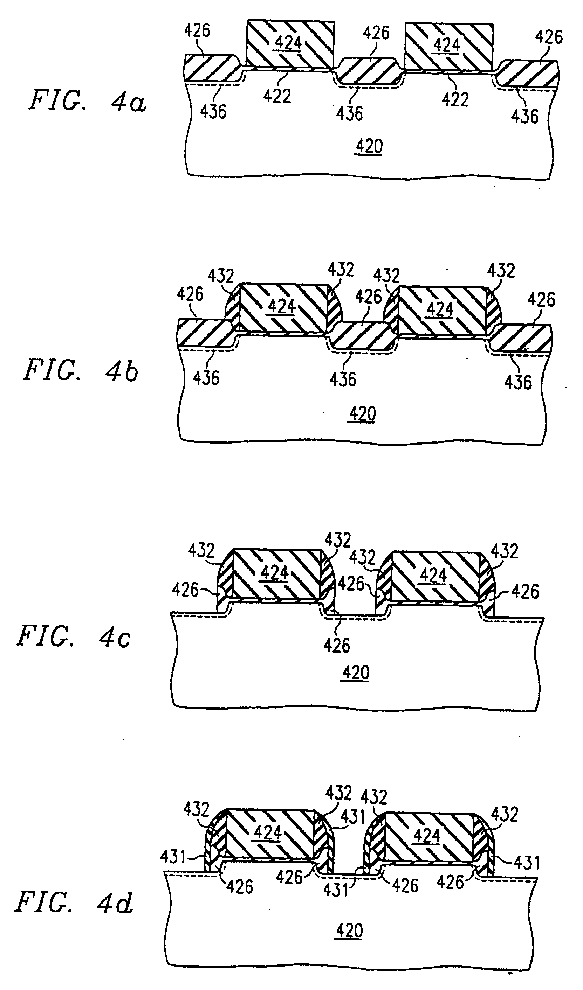

As a second preferred embodiment of the present invention avoids a problem that exists if the deglazing step shown in Figure 3d undercuts the pad oxide underneath the silicon nitride so severely that the silicon nitride is completely "lifted off". In this alternative embodiment, instead of removing the LOCOS oxide, the trench is dry etched through the LOCOS oxide. The first three steps of the alternative environment are identical with those shown in Figure 3b-3d and discussed above. In Figures 4a-4g, similar reference numerals are utilized to indicate similar elements to those of the embodiment illustrated in Figures 3b-3o. In Figure 4a, the LOCOS oxide 426 has already been grown. An optional channel stop 436, similar to the channel stop 336 shown in Figure 3i, has been implanted.

In Figure 4b, silicon nitride sidewalls are formed on either side of silicon nitride area 424 such that sidewalls appear on either side of the location in which the trench is to be etched. These sidewalls may be formed by deposition of silicon nitride followed by an isotropic dry etch, for example. Using the sidewalls to protect the side areas of the trench, the LOCOS oxide, is anisotropically etched, preferably using an oxide etch which has selectivity to silicon nitride. This results in the structure shown in Figure 4c in which the LOCOS oxide has been etched away where the trench is to be formed. The LOCOS oxide underneath the silicon nitride spacers is not etched because of the anisotropic nature of the etch that has been used. As described above, because silicon from the substrate is utilized in forming the LOCOS oxide, a depression 427 is formed in the surface of the silicon substrate 420.

Figure 4d shows an optional step which is only required if the silicon nitride sidewall was etched during the LOCOS etch. In this step, a second silicon nitride, or a silicon dioxide sidewall 431 is formed over sidewalls 432 and the remnants of the LOCOS oxide 426. The silicon nitride or silicon dioxide sidewalls can be formed by deposition of silicon nitride or silicon dioxide, respectively, followed by a dry etch, for example.

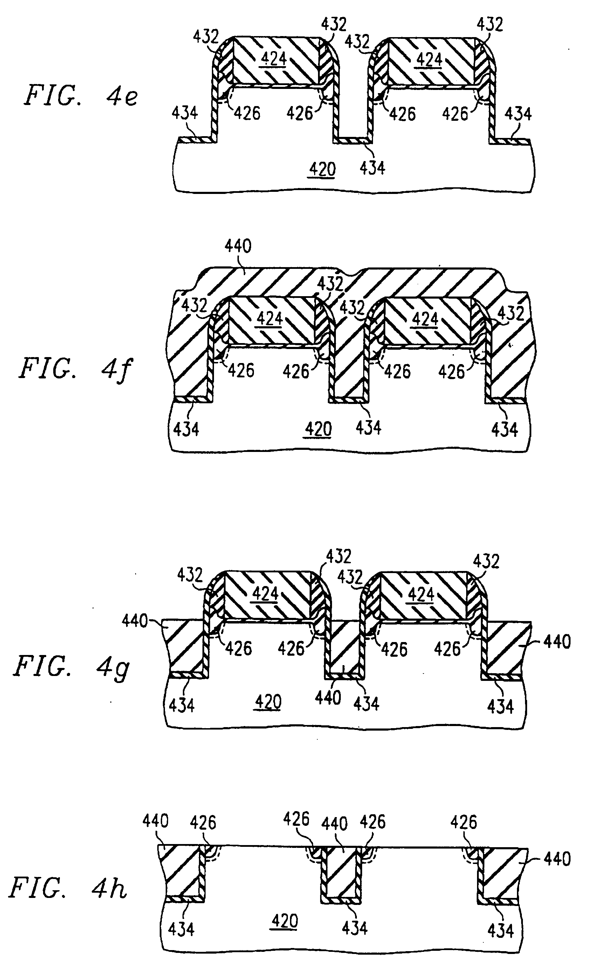

In Figure 4e, the silicon substrate is etched to form a shallow trench 434 and a protective oxide 438 is grown to line the surfaces of the trench 434. The protective oxide can be grown by thermal oxidation, for example. The process has now been completed to a point shown in Figure 4h in which trenches having sloped and rounded corners are complete. The trench isolation process will proceed from here with Figure 4f. In Figure 4f the trench is filled with a trench refill oxide 440 deposited by chemical vapor deposition (CVD), for example. That structure is subjected to chemical mechanical planarization, for example, to result in the structure shown in Figure 4g which is similar to the structure shown in Figure 3l. The processes of Figures 3m-3o can then be utilized to form the transistor and the integrated circuit may then be processed using conventional CMOS processes.

While a particular embodiment of the present invention has been disclosed herein, certain changes and modifications will readily occur to those skilled in the art. All such changes and modifications can be made without departing from the invention.

## Claims

1. A method of making a semiconductor device having a rounded-corner trench isolation structure comprising;
forming an oxide layer on a surface of a substrate at a location where a trench is to be formed;
removing said oxide layer to leave a depression in said surface at said trench location;
forming a dielectric layer on said surface;
anisotropically etching said dielectric layer to form dielectric spacers on sides of said trench location; and
etching a trench at said trench location.

2. The method as claimed in Claim 1 further comprising the step of:
removing said dielectric spacers;
filling said trench with a second dielectric material;
forming gate oxide over an active region of said device; and
forming gate polycrystalline silicon over said gate oxide.

3. The method as claimed in Claim 2 further comprising the step of:
planarizing a surface of the second dielectric material prior to the step of forming the gate oxide.

4. The method as claimed in Claim 2 or Claim 3 further comprising the step of:
forming a channel stop region in said trench region prior to the step of filling the trench with the second dielectric material.

5. The method as claimed in any of Claims 1 to 4, wherein the step of forming an oxide layer comprises forming a LOCOS oxide layer.

6. The method as claimed in any of Claim 5, further comprising the step of:
forming a patterned silicon nitride layer prior to the step of forming said oxide layer.

7. The method as claimed in any preceding claims, wherein the step of forming the first dielectric layer comprises forming a first dielectric layer comprising silicon dioxide.

8. The method as claimed in any of Claims 1 to 6, wherein the step of forming the first dielectric layer comprises forming a first dielectric layer comprising silicon nitride.

9. The method as claimed in any of Claims 2 to 8, wherein the step of filling the trench comprises filling the trench with a second dielectric layer comprising silicon dioxide.

10. The method as claimed in any of Claims 2 to 8, wherein the step of filling the trench comprises filling the trench with a second dielectric layer comprising silicon nitride.

11. The method as claimed in any preceding claim further comprising the step of:
forming a silicon nitride layer on a surface of a substrate prior to the step of forming said oxide layer, said silicon nitride layer being patterned to expose said surface at a location where a trench is to be formed.

12. The method as claimed in Claim 11 further comprising the step of:
removing the silicon nitride layer.

13. A method of making a semiconductor device having a rounded-corner trench isolation structure comprising;
forming an oxide layer on a surface of a silicon substrate at a location where a trench is to be formed;
forming silicon nitride sidewall spacers on sides of said oxide layer;
removing said oxide layer except in regions protected by said sidewall spacers;
and etching a trench at said trench location.

14. The method as claimed in Claim 13, wherein the step of forming the oxide layer comprises forming an oxide layer having a thickness of not more than substantially 1500 angstroms.

15. The method as claimed in Claims 13 or Claim 14, wherein the step of forming an oxide layer comprises forming a LOCOS oxide layer.

16. The method as claimed in any of Claims 13 to 15 further comprising:
filling the trench with a second dielectric material.

17. The method as claimed in Claim 16 further comprising the step of:
planarizing a surface of the second dielectric material.

18. The method as claimed in Claim 16 or Claim 17, wherein the step of filling the trench comprises filling the trench with a second dielectric layer comprising silicon dioxide.

19. The method as claimed in any of Claims 13 to 18 further comprising:
forming a patterned silicon nitride layer prior to the step of forming said oxide layer.

20. The method as claimed in any of Claims 13 to 19 further comprising:
forming a silicon nitride layer on a surface of a substrate prior to the step of forming said oxide layer, said silicon nitride layer being patterned to expose said surface at a location where a trench is to be formed.

21. The method as claimed in Claim 20 further comprising:
removing the patterned silicon nitride layer.

22. The method as claimed in Claim 20 or Claim 21 further comprising:
forming a gate oxide over an active area of the device; and
forming a gate polysilicon layer over the gate oxide.

23. The method as claimed in any of Claims 13 to 22 further comprising;
forming silicon dioxide sidewalls over the spacers prior to the step of etching the trench.

24. The method as claimed in any of Claims 13 to 23 further comprising:
anisotropically etching the oxide layer with an oxide etching solution having a selectivity to silicon dioxide.

25. A method of making an integrated circuit having a rounded-corner trench isolation structure comprising;
forming an oxide layer on a surface of a silicon substrate at a first trench location arranged to isolate a pair of semiconductor devices from each other, and at a second trench location to isolate at least one of said devices from a periphery of said integrated circuit;
forming silicon nitride sidewall spacers on sides of each of said trench locations;
removing said oxide layer except in regions protected by said sidewall spacers;
and etching a trench at said trench location.

26. A semiconductor device or integrated circuit manufactured in whole or in part by the method of any preceding claim.
